# EUROPEAN PATENT SPECIFICATION

(11) **EP 2 506 442 B1**
(45) Date of publication and mention of the grant of the patent: **22.05.2013**
(21) Application number: 11290161.6
(22) Date of filing: 31.03.2011
(51) Int. Cl.: H04B 1/04, H03G 3/30, H04B 1/18

(54) **Radio head device and method of operating a radio head device**
Funkkopfvorrichtung und Verfahren zum Betrieb einer Funkkopfvorrichtung
Dispositif de tête de radio et son procédé de fonctionnement

(43) Date of publication of application: 03.10.2012
(73) Proprietor: Alcatel Lucent, 75007 Paris (FR)
(72) Inventor: Wiegner, Dirk, 71409 Schwaikheim (DE)
(74) Representative: Wetzel, Emmanuelle

(56) References cited:
- US-A1- 2003 020 558
- US-A1- 2005 085 194
- US-A1- 2007 087 776
- US-A1- 2010 151 898

## Description

### Field of the invention

The present invention relates to a radio head device for receiving an input signal from an external signal processing unit and for providing a radio frequency, RF, output signal which depends on said input signal.

The present invention further relates to a method of operating a radio head device.

Still further, the present invention relates to a signal processing unit for supplying a radio head device with an input signal and a method of operating such signal processing unit.

### Background

The radio coverage of a wireless communications system such as a cellular radio network is usually provided by several base stations each of which maintains wireless communications with one or more terminals via respective antennas. A base station comprises baseband processing means that perform baseband signal processing and put out at least one signal representative of data to be transmitted to the terminals.

In order to increase flexibility of the base stations, it is desirable to allow the antennas - or at least circuitry which should be arranged close to the antennas - to be located remote from the baseband processing unit which has lead to the development of discrete radio head devices that receive data supplied by the baseband processing means and convert said data to a suitable form for transmission by an antenna.

US 2010/151898 Al discloses a transmitter/receiver for a wireless communication system.

It is an object of the present invention to provide an improved radio head device and an improved method of operating a radio head device which enable a higher degree of flexibility regarding signal processing and transmission.

### Summary

According to the present invention, regarding the abovementioned radio head device, this object is achieved by said radio head device comprising an input interface that is configured to receive a digitally modulated input signal from said external signal processing unit, digital to analog, D/A, reconstruction means to transform said digitally modulated input signal into an analog input signal, and amplifier means configured to amplify said analog input signal depending on an amplification and/or attenuation applied to a signal said input signal from the external processing unit is derived from, wherein said amplifier means are configured to apply a variable gain and/or attenuation to the analog input signal to be amplified.

Thus, the analog signal processed within the radio head device may advantageously be attenuated or amplified which yields a further degree of freedom regarding signal processing. Particularly, the inventive principle advantageously enables to transmit the digitally modulated input signal i.e. with a maximum signal power level to the radio head device regardless of an actual desired signal power level. Only within the inventive radio head device, by means of the controllable amplifier, the received digitally modulated input signal, or the analog signal derived therefrom, respectively, may be amplified and/or attenuated as required to re-establish an actual desired signal power level again. Since the amplification and/or attenuation of the analog signal within the radio head device is performed depending on an amplification and/or attenuation applied to a signal said input signal from the external processing unit is derived from, an optimum coordination between the various amplification/attenuation stages is enabled. For instance, within said external processing unit, a first amplification and/or attenuation of a signal processed therein may be performed. From a so obtained amplified / attenuated signal, the input signal for the radio head device may be obtained, which is forwarded from the signal processing unit to the radio head device. Within the radio head device according to the embodiments, a further, i.e. second, step of amplification and/or attenuation may be performed. Thus advantageously, by performing the first amplification and/or attenuation, i.e. external to the radio head device, preferably within the signal processing unit, a signal to be forwarded as input signal to the radio head device may optimally be conditioned according to signal processing criteria associated with the signal processing unit and/or a data transmission link between the signal processing unit and the radio head device, i.e. preferably independent of a desired overall amplification/attenuation with respect to an output signal of the radio head device. Only in the radio head device, the analog signal obtained therein may further be amplified and/or attenuated in order to achieve the desired overall amplification/attenuation of the processed signal. Thus, by operating the amplifier means of the radio head device in a coordinated manner with respect to an amplification and/or attenuation of the signal processed within the signal processing unit, advantages over prior art can be achieved by realising optimum signal conditions for the signal processing stages preceding the radio head device without sacrificing an overall amplification / attenuation of the RF output signal obtained at an output of the radio head device, that may be tuned by the amplifier means that are included in the radio head device and that are operated depending on an amplification and/or attenuation applied to the signal said input signal from the external processing unit is derived from.

According to a preferred embodiment, said amplifier means comprise variable preamplifier means that are configured to apply a variable gain and/or attenuation to said analog input signal to obtain a preamplified input signal. The preamplifier means may e.g. be controlled by a local control unit arranged within the radio head device and/or a remote control unit such as e.g. a control unit of an external signal processing unit which also provides the digitally modulated input signal. This variant is particularly advantageous since it enables to coordinate the gain/attenuation control of the analog signal within the radio head device with further signal processing stages which are e.g. involved in processing the digitally modulated input signal for the radio head device.

According to a further embodiment, said amplifier means further comprise at least one power amplifier that is configured to amplify said preamplified input signal. With this configuration, the inventive gain/attenuation control may e.g. be performed by the preamplifier means, whereas the power amplifier may be configured to exhibit a constant gain factor. Alternatively, the power amplifier may also comprise a variable gain/attenuation factor.

According to a further embodiment, a feedback path is provided for linearization of said RF output signal. Said feedback path may e.g. be designed as a local feedback path which receives a portion of a processed signal, e.g. the output signal of the power amplifier. Said signal portion is fed back in a per se known manner to at least one preceding stage of a signal processing chain within the radio head device to influence a processed signal depending on the feedback signal. Thus, in a per se known manner, nonlinearities which are e.g. introduced by the power amplifier, may be compensated. Alternatively or additionally to a local feedback path within the radio head device, a feedback path which also includes a signal processing unit that provides the digitally modulated input signal to the radio head device may be provided.

A further solution to the object of the present invention is provided by a method of operating a radio head device for receiving an input signal from an external signal processing unit and for providing a radio frequency, RF, output signal which depends on said input signal, wherein said method comprises the following steps: receiving a digitally modulated input signal from said external signal processing unit by means of an input interface, transforming said digitally modulated input signal into an analog input signal by means of digital to analog, D/A, reconstruction means, amplifying said analog input signal by means of amplifier means which are configured to apply a variable gain or attenuation to the analog input signal to be amplified.

According to a further embodiment, said amplifier means comprise variable preamplifier means that apply a variable gain and/or attenuation to said analog input signal to obtain a preamplified input signal, wherein said amplifier means further comprise at least one power amplifier that amplifies said preamplified input signal.

According to a further embodiment, said variable gain and/or attenuation is controlled by said external signal processing unit which provides the digitally modulated input signal.

A further solution to the object of the present invention is provided by a signal processing unit for supplying a radio head device, particularly a radio head device according to the embodiments, with an input signal, wherein said signal processing unit comprises a signal modulator which is configured to receive an input signal and to transform said input signal into a digitally modulated signal.

According to a further embodiment, said signal processing unit comprises preamplifier means that are configured to supply said signal modulator with said input signal at a predetermined input power level, which advantageously enables to operate the signal modulator at an optimum operating point. For instance, if the signal modulator is a bandpass delta sigma modulator (BPDSM), due to the noise-shaping properties of such BPDSM, it is advantageous to supply the BPDSM with an input signal of a specific signal power in order to attain an optimum signal to noise ratio (SNR) of an analog signal which may be obtained by filtering the digitally modulated signal which is obtained at an output of the BPDSM. A further adaptation of the signal power may later on be performed within the inventive radio head device by means of the controllable amplifier/preamplifier.

According to a particularly preferred embodiment, said preamplifier means are configured to supply said signal modulator with said input signal at a constant input power level, which e.g. corresponds with a maximum SNR of the analog signal obtained by filtering the digitally modulated signal.

According to a further preferred embodiment, said signal processing unit is configured to control a gain factor and/or attenuation of amplifier means which are arranged within said radio head device and which are configured to apply a variable gain and/or attenuation to an analog signal that is processed within said radio head device.

Preferably, said signal processing unit is configured to control said gain factor and/or attenuation of said amplifier means which are arranged within said radio head device depending on an operation of said preamplifier means, particularly depending on a gain factor and/or attenuation of said preamplifier means, whereby a proper signal amplitude level at an output of the radio head device may be attained, regardless of an actual gain or attenuation of the signal fed to the digital modulator in the baseband signal processing unit for optimizing the modulator's SNR.

According to a further preferred embodiment, said signal modulator is a bandpass delta sigma modulator, BPDSM.

A further solution to the object of the present invention is provided by a method of operating a signal processing unit for supplying a radio head device, particularly a radio head device according to the embodiments, with an input signal, wherein said signal processing unit comprises a signal modulator which is configured to receive an input signal and to transform said input signal into a digitally modulated signal, wherein said method comprises preamplifier means supplying said signal modulator with said input signal at a predetermined, preferably constant, input power level.

Generally, the input signal to the digital modulator may already comprise digital form. For instance, an I/Q-modulated digital input signal may be provided to the input of the digital modulator that transforms the I/Q-modulated digital input signal into e.g. a bandpass delta sigma-modulated output signal.

According to a preferred embodiment, said signal processing unit controls a gain factor and/or attenuation of amplifier means which are arranged within said radio head device and which are configured to apply a variable gain and/or attenuation to an analog signal that is processed within said radio head device, wherein said signal processing unit preferably controls said gain factor and/or attenuation of said amplifier means depending on an operation of said preamplifier means, particularly depending on a gain factor and/or attenuation of said preamplifier means.

### Brief description of the figures

Further features, aspects and advantages of the present invention are given in the following detailed description with reference to the drawings in which:
- Figure 1: depicts a schematic block diagram of a communications scenario involving a base station and two mobile terminals,
- Figure 2: depicts a simplified block diagram of a radio head device according to an embodiment,
- Figure 3: depicts a detailed block diagram of amplifier means of a radio head device according to an embodiment,
- Figure 4: depicts a block diagram of a radio head device according to a further embodiment,
- Figure 5: depicts a block diagram of signal processing means according to an embodiment, and
- Figure 6: depicts a simplified flow chart of a method according to an embodiment.

### Description of the Embodiments

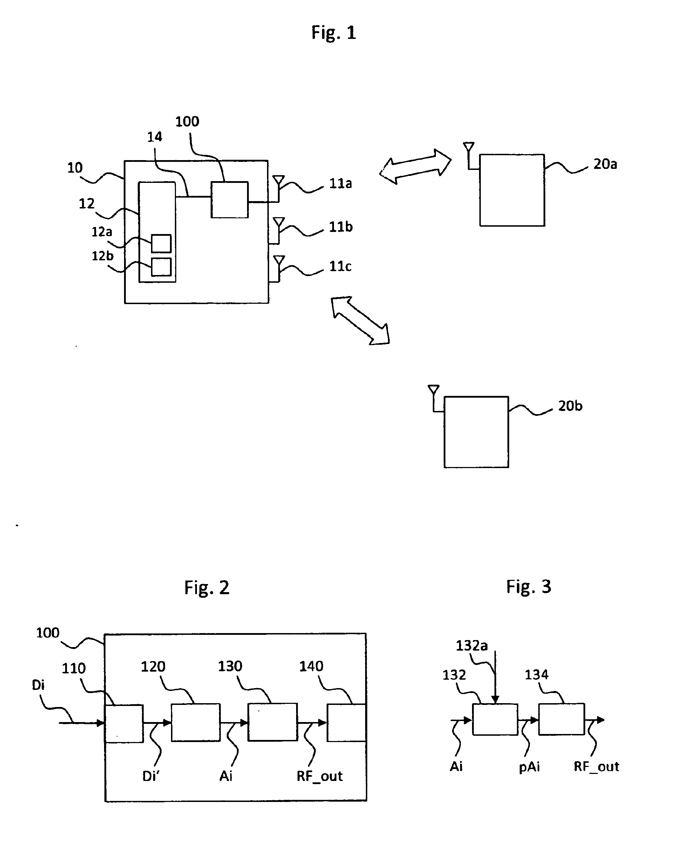

Figure 1 depicts a communications scenario involving a base station 10 of a cellular communications network and two mobile terminals 20a, 20b.

The base station 10 comprises a plurality of antennas 11a, 11b, 11c for exchanging radio frequency, RF, signals with corresponding antennas of the mobile terminals 20a, 20b in a per se known manner, e.g. such as according to one of the standards: GSM, UMTS, LTE. A central baseband signal processing unit 12 is provided in said base station 10 which performs basic baseband signal processing tasks such as signal creation, multi-carrier synthesis, clipping and the like.

A radio head device 100 is also associated with the base station 10. The radio head device 100 is configured to receive data, i.e. an input signal, from the baseband processing unit 12 via a transmission link 14, to process said received data in a way disclosed in detail below, and to transmit processed data to at least one antenna 11a of said base station 10 for transmission to the terminals 20a, 20b. Generally, the radio head device 100 comprises processing capabilities that enable to transform the signals received from said baseband processing unit 12 into any form suitable for output to the antennas 11a, .. or further transmission means suitable for transmitting RF signals.

It is to be noted that figure 1, particularly with respect to base station 10, merely illustrates a logical structure of base station 10 and not necessarily a physical arrangement of its components 11a, 11b, 11c, 12, 14, 100. Preferably, the various components 11a, 11b, 11c, 12, 14, 100 of the base station 10 are arranged at different locations, i.e. remote from each other. A particularly preferred configuration provides the baseband processing unit 12 to be located at a first location, such as a utility room of a building or the like. The further components 100, 11a, 11b, 11c are preferably located remote from said baseband processing unit 12, for instance on the top of a roof of the same building. It is also possible to arrange the radio head device 100 and its associated antennas 11a, 11b, 11c even further away from the baseband processing unit 12 such as e.g. in another building or even some kilometres away from the first location of the baseband processing unit 12.

For this purpose, in order to facilitate robust and high data rate signal transmission from the baseband processing unit 12 to the radio head device 100, the transmission link 14 is designed as a digital transmission link. I.e., a digital data format is used for data transmission from the baseband unit 12 to the radio head device 100. According to a preferred embodiment, a 1-bit digital modulation scheme is used for transmitting data via said transmission link. For instance, the digital signal provided by the baseband processing unit 12 may comprise a typical one-bit modulation scheme such as bandpass-delta-sigma, pulse length, a combination thereof or other schemes known in the art. Although transmission link 14 may comprise electrical conductors and cables made thereof, a further particularly preferred variant for the transmission link 14 is an optical transmission link comprising one or more optical fibers. Combined electric and optical transmission links may also be provided.

Thus, according to an exemplary embodiment, the baseband processing unit 12 comprises a signal modulator 12a (figure 1) and electro-optical conversion means 12b (e.g., a laser diode) which supply a digital optical signal to the optical transmission link 14. This digital optical signal is representative of data to be transmitted by said base station 10 to the terminals 20a, 20b and may correspondingly comprise one or more respective data streams as supplied by the signal modulator 12a.

Figure 2 depicts a schematic block diagram of a radio head device 100 according to an embodiment. As can be gathered from figure 2, the radio head device 100 comprises an input interface 110 that is configured to receive said digitally modulated, preferably optical, input signal Di that is transmitted by the baseband signal processing unit 12 (figure 1) via said link 14 to the radio head device 100 in the above explained manner. Alternatively, if the transmission link is of the electrical type, the input interface is configured respectively.

The input interface 110 may also comprise optoelectric conversion means (not shown) which enable a conversion of an optical digitally modulated input signal Di into an electric digitally modulated input signal Di'.

The radio head device 100 also comprises digital to analog, D/A, reconstruction means 120 to transform said digitally modulated input signal Di' into an analog input signal Ai. The D/A reconstruction means 120 may e.g. comprise a reconstruction filter.

The radio head device 100 further comprises amplifier means 130 which are configured to amplify said analog input signal Ai, wherein said amplifier means 130 are configured to apply a variable gain and/or attenuation to the analog input signal Ai to be amplified. Thus, the output power level of an RF output signal RF_out obtained at an output of said amplifier means 130 may be controlled, whereby a further degree of freedom for conditioning the output signal RF_out is obtained.

The RF output signal RF_out may e.g. be forwarded to an antenna system 11a (Fig. 1) which is connected to an output port 140 of the radio head device 100 (Fig. 2).

Generally, there are various ways to obtain an output signal RF_out which is in the RF range, i.e. ready for being transmitted by means of the antenna 20a. For instance, the baseband processing unit 12 may provide said digitally modulated input signal Di in the RF range, which e.g. requires an upconversion process within the unit 12. In this case, obviously, no further upconversion is required within the radio head device 100 to obtain an RF output signal RF_out.

Alternatively, the baseband processing unit 12 may provide said digitally modulated input signal Di in a baseband or an intermediate frequency (IF) range to the radio head device 100 via link 14. In this case, the radio head device 100 would be required to perform the upconversion, i.e. by multiplying an analog signal Ai obtained from the reconstruction means 120 with a local oscillator frequency signal that effects the transformation of the analog signal Ai to the RF range.

Figure 3 depicts a block diagram of the amplifier means 130 of a radio head device 100 according to an embodiment. The amplifier means 130 comprise variable preamplifier means 132 which receive the analog input signal Ai and which are configured to apply a variable gain and/or attenuation to said analog input signal Ai to obtain a preamplified input signal pAi.

Said amplifier means 130 further comprise at least one power amplifier 134 that is configured to amplify said preamplified input signal pAi. With this configuration, a gain/attenuation control may e.g. be performed by the preamplifier means 132, whereas the power amplifier 134 may be configured to exhibit a constant gain factor. Alternatively, the power amplifier 134 may also comprise a variable gain/attenuation factor.

The gain/attenuation control of the controllable preamplifier 132 is symbolized by the arrow 132a of Figure 3. For example, the preamplifier 132 may be controlled by a control device (not shown) which is local to the radio head device 100. According to a further preferred embodiment, the preamplifier 132 may be controlled by the signal processing unit 12 (Fig. 1). Respective information may be exchanged between the devices 12, 100 via said link 14, e.g. in a dedicated control channel or the like, or via a separate data connection (not shown).

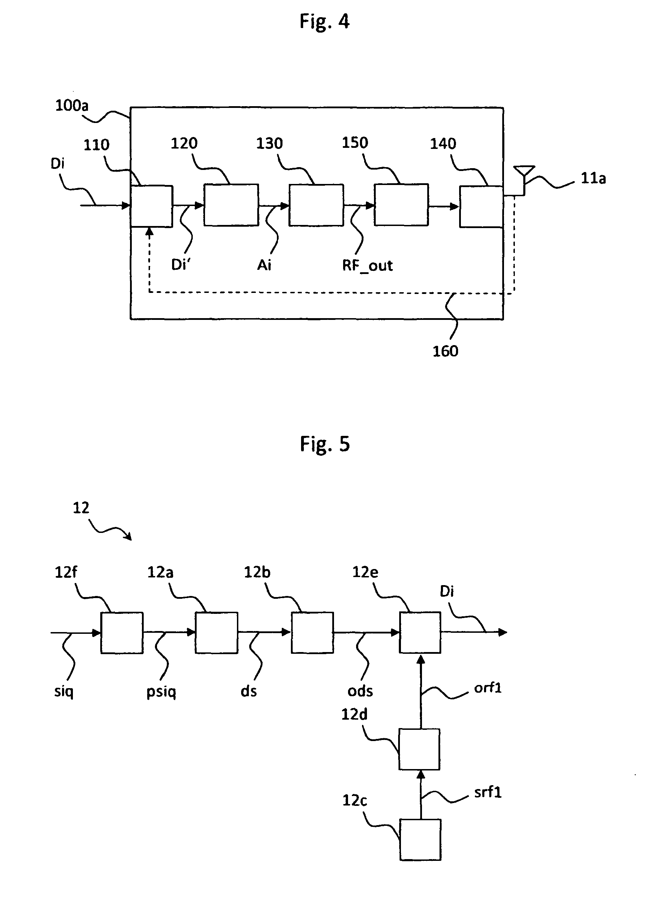

Figure 4 depicts a block diagram of a radio head device 100a according to a further embodiment. In addition to the configuration 100 explained above with reference to Fig. 2, the radio head device 100a according to Fig. 4 comprises an antenna filter 150 which filters the RF output signal RF_out to ensure that only desired frequency components of the RF output signal RF_out are forwarded to the output port 140 for supplying the antenna 11a.

Moreover, the radio head device 100a comprises a feedback path 160 which can be used for linearization of said RF output signal RF_out in a per se known manner. According to the present embodiment, said feedback path 160 is designed as a local feedback path (with respect to the radio head device 100a) which receives a portion of a processed signal, e.g. the output signal as delivered to the antenna 11a. Alternatively, a feedback signal portion may be obtained at an output of the amplifier means 130. Said feedback signal portion is fed back to at least one preceding stage 110 of the signal processing chain within the radio head device 100a to influence a processed signal depending on the feedback signal. For example, the input interface 110 may comprise an input for receiving the feedback signal and may further be configured to influence, i.e. modify, the input signal Di' so as to compensate nonlinearities introduced by the signal processing within the components 120, 130, 150, 140.

Presently, the feedback path 160 does not require downconversion of the feedback signal portion since the radio head device 100a receives an input signal Di which is already in a target RF range, i.e. the feedback processing is also performed within the RF range.

Alternatively or additionally to a local feedback path 160 within the radio head device 100a, a feedback path (not shown) which also includes the signal processing unit 12 that provides the digitally modulated input signal Di to the radio head device 100a may be provided. Such feedback path may eventually require downconversion means to transform the feedback signal portion from the RF range to a lower frequency range, i.e. IF range or baseband range.

Fig. 5 depicts a block diagram of a signal processing unit 12 according to an embodiment. The signal processing unit 12 may be employed within the base station 10 to perform basic baseband signal processing tasks such as digital signal modulation, carrier synthesis, clipping, and the like.

At an input, the signal processing unit 12 receives a digital input signal, e.g. an I/Q-modulated signal siq. The I/Q-modulated input signal siq is supplied to preamplifier means 12f which are configured to apply a controllable gain and/or attenuation to the I/Q-modulated input signal siq, i.e. to scale the I/Q-modulated input signal siq by a predetermined factor, whereby the preamplified input signal psiq for the digital modulator 12a is obtained.

Thus, the digital modulator 12a can advantageously be provided with said input signal psiq at a predetermined input power level, preferably a constant input power level.

This is particularly advantageous for such configurations, according to which the digital modulator 12a is a bandpass delta sigma modulator (BPDSM), because a signal to noise ratio (SNR) of the digitally modulated signal ds as obtained at an output of the BPDSM 12a depends on the input power level of the input signal psiq due to noise shaping characteristics of the BPDSM.

In other words, the preamplifier means 12f of the baseband signal processing unit 12 advantageously enable to provide the BPDSM 12a with an optimum input power level regarding an SNR of the digitally modulated output signal ds of the BPDSM 12a. I.e., according to a preferred embodiment, regardless of an actually desired power level for the RF output signal RF_out, the BPDSM 12a is operated to provide a digitally modulated output signal ds with maximum SNR (linearity optimum). An adaptation of the actual power level of the digitally modulated signal, or rather the further signals Ai (Fig. 2) derived therefrom, is only later on performed within the radio head device 100 according to the embodiments, i.e. by employing the controllable amplifier means 130 or the preamplifier means 132 (Fig. 3).

Thus, the system according to the embodiments advantageously enables to provide a digital input signal for the radio head device 100, 100a having maximum SNR and linearity, while at the same time being able to influence the signal power level within the radio head device 100, 100a in order to attain a desired power level of the RF output signal RF_out.

In contrast, conventional baseband processing systems, which control the input power level of the input signal to a BPDSM in order to control the power level of the RF output signal, suffer from smaller SNRs. For instance, in order to reduce the power level of the RF output signal of a conventional radio head device (e.g., during low-load situations), conventional baseband processing systems reduce an input power level of the input signal to a BPDSM correspondingly, which leads to a reduced SNR and linearity. This significant disadvantage is overcome by the embodiments of the present invention, since it is ensured that the BPDSM 12a can always be operated at its SNR and linearity optimum.

Alternatively or additionally to implementing the amplification / attenuation in the digital domain, as presently enabled by the preamplifier means 12f (Fig. 5), it is also possible to provide signal amplification and/or attenuation upstream the BPDSM 12a in the analog domain. Depending on the type of input signal siq (i.e., digital or analog), corresponding conversions to and/or from the analog/digital domain have to be performed. For instance, the digital input signal siq according to Fig. 5 may be converted by D/A converter means (not shown) to the analog domain, and a so obtained analog input signal may be amplified or attenuated in the analog domain by a respectively adapted analog preamplifier (not shown). After that, the preamplified and/or attenuated analog signal may be converted to the digital domain again for forwarding to the BPDSM 12a.

Alternatively or additionally, the BPDSM 12a may also be implemented as an ASIC (application specific integrated circuit) or the like which is configured to directly receive analog input signals. These analog input signals, again, could be amplified and/or attenuated by an analog preamplifier associated with the BPDSM 12a.

According to an embodiment, the digitally modulated signal ds as obtained at the output of the BPDSM 12a may be forwarded to electro-optic conversion means 12b which transform the electrical digitally modulated signal ds into an optical digitally modulated signal ods. An electric local oscillator signal srf1, which may e.g. already be in the RF range, is provided by the local oscillator means 12c and is converted to an optical local oscillator signal orf1 by the further electro-optic conversion means 12d.

Adder means 12e perform an addition of both signals ods, orf1 to obtain the digital signal Di, which is employed as the input signal for the radio head device 100, 100a. Since according to the present embodiment, the digital input signal Di already comprises the desired RF component orf1, the radio head device 100, 100a is not required to provide a local oscillator for upconversion purposes. The input interface 110 or their integrated opto-electrical converter means, respectively, may rather employ the principle of optical heterodyning, whereby the optical digitally modulated signal ods is implicitly upconverted, i.e. transformed, into an electrical digital data signal in the RF range, depending on the frequency of the local oscillator signal srf1. The intensity of electrical digital signals Di' obtained at an output of the opto-electrical converter means varies with a frequency only depending on the spectral components of the signals ods, orf1, as all higher frequency components of the intensity, i.e. in the range of the optical carrier wave, are time-averaged in the opto-electrical converter as known by the skilled man. Preferably, the opto-electrical converter means may comprise a PIN-diode or an avalanche-photo-diode.

If the signal upconversion to the RF range is to be performed within the radio head device 100, the baseband signal processing unit 12 may directly transmit the optical digitally modulated signal ods as the input signal Di to the radio head device 100, i.e. the components 12c, 12d, 12e are not required. In this case, the radio head device 100 should rather comprise corresponding upconversion means (not shown), which e.g. effect a multiplication of the analog signal Ai with a local oscillator signal in the desired RF range. Such upconversion means may e.g. be arranged between the D/A reconstruction means 120 (Fig. 2) and the amplifier means 130 or the preamplifier means 132 (Fig. 3) respectively.

The signal processing according to the embodiments, which provides for a controlled amplification and/or attenuation of the input signal psiq for the digital modulator 12a, particularly the BPDSM, and/or for a controlled amplification and/or attenuation of the input signal Ai, pAi (Fig. 3) for the power amplifier 130, yields superior linearity as compared to conventional systems, regardless of where an upconversion is performed (baseband unit 12 or radio head device 100, 100a).

According to a particularly advantageous embodiment, said signal processing unit 12 is configured to control a gain factor and/or attenuation of the amplifier means 130, 132 (Fig. 2, 3), which are arranged within the radio head device 100, 100a, particularly depending on a gain factor and/or attenuation of said preamplifier means 12f, whereby an overall gain or attenuation for the obtained RF output signal RF_out may advantageously be precisely controlled by the signal processing unit 12.

For instance, if the signal processing unit 12 operates the preamplifier means 12f with a particularly large gain factor in the sense of SNR optimization for the output signal of the BPDSM 12a, the signal processing unit 12 may correspondingly control the amplifier means 130, 132 with a reduced gain factor or with an increased attenuation, respectively, to attain the actual desired overall gain affecting the signal power of the RF output signal RF_out.

On the other hand, if the input power level of the signal siq is already too high for reaching the BPDSM's SNR optimum, the signal processing unit 12 may advantageously control the preamplifier means 12f to attenuate the input signal siq by a predetermined amount so as to achieve the proper signal power level for the preamplified signal psiq delivered to the BPDSM 12a. Again, a further adaptation of the RF signal's power level may be established by controlling the variable preamplifier 132 or the controllable amplifier means 130, generally.

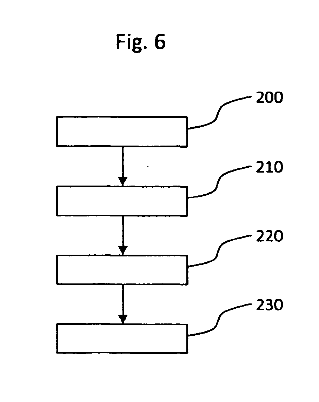

Figure 6 depicts a simplified flow chart of a method according to an embodiment.

In a first step 200, the processing unit 12 controls its preamplifier means 12f to supply the digital signal modulator 12a with an input signal psiq at a predetermined, preferably constant, input power level, which preferably corresponds with the input power level for which the digital signal modulator 12a comprises its SNR optimum.

After that, in step 210, digital signal modulator 12a generates a digitally modulated signal ds, which eventually is transformed to an optical signal ods, and which may or may not be combined with a local oscillator signal within the processing unit 12 as already explained above.

In step 220, the radio head device 100, 100a receives the digitally modulated input signal Di, which depends on the signal ds, and transforms it into the analog input signal Ai.

After that, the amplifier means 130 or the preamplifier means 132 of the radio head device 100, 100a are controlled in step 230 so as to effect a desired gain or attenuation to the analog input signal Ai in order to provide an RF output signal RF_out at the desired signal power level.

Preferably, the signal processing unit 12 controls both controllable (pre-)amplifier means 12f, 130, 132 so as to optimally coordinate an overall gain factor while ensuring an optimized SNR of the digitally modulated signal ds obtained from the digital modulator 12a.

By applying the principle according to the embodiments, the linearity optimum of the BPDSM 12a can be attained for all possible load situations, i.e. desired RF signal power levels of the RF output signal RF_out.

The radio head device 100, 100a according to the embodiments is not limited to be used in / with base stations 10 of communications networks. It may rather be used in any target system that provides digitally modulated input signals Di which are to be transformed in analog RF output signals RF_out.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

The functions of the various elements shown in the FIGs., including any functional blocks labelled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the FIGS. are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. Radio head device (100), for receiving an input signal from an external signal processing unit (12) and for providing a radio frequency, RF, output signal (RF_out) which depends on said input signal, wherein said radio head device (100) comprises:
- an input interface (110) that is configured to receive a digitally modulated input signal (Di) from said external signal processing unit (12),
- digital to analog, D/A, reconstruction means (120) configured to transform said digitally modulated input signal (Di, Di') into an analog input signal (Ai), and
- amplifier means (130) configured to amplify said analog input signal (Ai) depending on an amplification and/or attenuation applied to a signal (siq) said input signal (Di) from the external processing unit (12) is derived from, wherein said amplifier means (130) are configured to apply a variable gain and/or attenuation to the analog input signal (Ai) to be amplified,
- wherein said amplifier means (130) are configured to be controlled by said external signal processing unit (12).

2. Radio head device (100) according to claim 1, wherein said amplifier means (130) comprise variable preamplifier means (132) that are configured to apply a variable gain and/or attenuation to said analog input signal (Ai) to obtain a preamplified input signal (pAi).

3. Radio head device (100) according to claim 2, wherein said amplifier means (130) further comprise at least one power amplifier (134) that is configured to amplify said preamplified input signal (pAi).

4. Radio head device (100) according to one of the preceding claims, wherein a feedback path (160) is provided for linearization of said RF output signal (RF_out).

5. Method of operating a radio head device (100) for receiving an input signal from an external signal processing unit (12) and for providing a radio frequency, RF, output signal (RF_out) which depends on said input signal, wherein said method comprises the following steps:
- receiving a digitally modulated input signal (Di) from said external signal processing unit (12) by means of an input interface (110),
- transforming said digitally modulated input signal (Di, Di') into an analog input signal (Ai) by means of digital to analog, D/A, reconstruction means (120),
- amplifying said analog input signal (Ai) by means of amplifier means (130) which are configured to apply a variable gain or attenuation to the analog input signal (Ai) to be amplified,
- wherein said amplifier means (130) are configured to be controlled by said external signal processing unit (12) and apply said variable gain and/or attenuation to the analog input signal (Ai) depending on an amplification and/or attenuation applied to a signal (siq) said input signal (Di) from the external processing unit (12) is derived from.

6. Method according to claim 5, wherein said amplifier means (130) comprise variable preamplifier means (132) that apply a variable gain and/or attenuation to said analog input signal (Ai) to obtain a preamplified input signal (pAi), and wherein said amplifier means (130) further comprise at least one power amplifier (134) that amplifies said preamplified input signal (pAi).

7. Method according to one of the claims 5 to 6, wherein said variable gain and/or attenuation is controlled by said external signal processing unit (12) which provides the digitally modulated input signal (Di).

8. System comprising
a) a signal processing unit (12) for supplying a radio head device (100), particularly a radio head device (100) according to one of the claims 1 to 4, with an input signal (Di), wherein said signal processing unit (12) comprises a signal modulator (12a) which is configured to receive an input signal (psiq) and to transform said input signal (psiq) into a digitally modulated signal (ds), and
b) at least one radio head device (100) according to one of the claims 1 to 4, wherein said radio head device (100) is associated with said signal processing unit (12).

9. System according to claim 8, wherein said signal processing unit (12) comprises preamplifier means (12f) that are configured to supply said signal modulator (12a) with said input signal (psiq) at a predetermined input power level.

10. System according to claim 9, wherein said preamplifier means (12f) are configured to supply said signal modulator (12a) with said input signal (psiq) at a constant input power level.

11. System according to one of the claims 8 to 10, wherein said signal processing unit (12) is configured to control a gain factor and/or attenuation of amplifier means (130, 132) which are arranged within said radio head device (100) and which are configured to apply a variable gain and/or attenuation to an analog signal (Ai) that is processed within said radio head device (100).

12. System according to claim 11, wherein said signal processing unit (12) is configured to control said gain factor and/or attenuation of said amplifier means (130, 132) which are arranged within said radio head device (100) depending on an operation of said preamplifier means (12f), particularly depending on a gain factor and/or attenuation of said preamplifier means (12f).

13. System according to one of the claims 8 to 12, wherein said signal modulator (12a) is a bandpass delta sigma modulator, BPDSM.

## Patentansprüche

1. Funkkopfvorrichtung (100) zum Empfangen eines Eingangssignals von einer externen Signalverarbeitungseinheit (12) und zum Bereitstellen eines Radiofrequenz- bzw. RF-Ausgangssignals (RF_out), welches von dem besagten Eingangssignal abhängt, wobei die besagte Funkkopfvorrichtung (100) umfasst:
- Eine Eingangsschnittstelle (110), welche für den Empfang eines digital modulierten Eingangssignals (Di) von der besagten externen Signalverarbeitungseinheit (12) konfiguriert ist,
- Digital-zu-Analog- bzw. D/A-Wiederherstellungsmittel (120), weiche für das Umwandeln des besagten digital modulierten Eingangssignals (Di, Di') in ein analoges Eingangssignal (Ai) konfiguriert sind, und
- Verstärkermittel (130), welche für das Verstärken des besagten analogon Eingangssignals (Ai) in Abhängigkeit von einer auf ein Signal (siq), von welchem das besagte Eingangssignal (Di) von der externen Verarbeitungseinheit (12) abgeleitet ist, angewendeten Verstärkung und/oder Dämpfung konfiguriert sind, wobei die besagten Verstärkermittel (130) für das Anwenden einer variablen Verstärkung und/oder Dämpfung auf das zu verstärkende analoge Eingangssignal (Ai) konfiguriert sind,
- wobei die besagten Verstärkermittel (130) konfiguriert sind, um von der besagten externen Signalverarbeitungseinheit (12) gesteuert zu werden.

2. Funkkopfvorrichtung (100) nach Anspruch 1, wobei
die besagten Verstärkermittel (130) variable Vorverstärkermittel (132) umfassen, weiche für das Anwenden einer variablen Verstärkung und/oder Dämpfung auf das besagte analoge Eingangssignal (Ai) konfiguriert sind, um ein vorverstärktes Eingangssignal (pAi) zu erhalten.

3. Funkkopfvorrichtung (100) nach Anspruch 2, wobei die besagten Verstärkermittel (130) weiterhin mindestens einen Leistungsverstärker (134) umfassen, weicher für das Verstärken des besagten vorverstärkten Eingangssignals (pAi) konfiguriert ist.

4. Funkkopfvorrichtung (100) nach einem der vorstehenden Ansprüche, wobei ein Rückkopplungspfad (160) für die Linearisierung des besagten RF-Ausgangssignals (RF_out) bereitgestellt wird.

5. Verfahren für den Betrieb einer Funkkopfvorrichtung (100) zum Empfangen eines Eingangssignals von einer externen Signalverarbeitungsvorrichtung (12) und zum Bereitstellen eines Radiofrequenz- bzw. RF-Ausgangssignals (RF_out), welches von dem besagten Ausgangssignal abhängt, wobei das besagte Verfahren die folgenden Schritte umfasst:
- Empfangen eines digital modulierten Eingangssignals (Di) von der besagten externen Signalverarbeitungseinheit (12) über eine Eingangsschnittstelle (110),
- Umwandeln des besagten digital modulierten Eingangssignals (Di, Di') in ein analoges Eingangssignal (Ai) anhand der Digital-zu-Analog- bzw. D/A-Wiederherstellungsmittel (120),
- Verstärken des besagten analogen Eingangssignals (Ai) anhand der Verstärkermittel (130), welche für das Anwenden einer variablen Verstärkung und/oder Dämpfung auf das zu verstärkende analoge Eingangssignal (Ai) konfiguriert sind,
- wobei die besagten Verstärkermittel (130) konfiguriert sind, um von der besagten externen Signalverarbeitungseinheit (12) gesteuert zu werden und die besagte variable Verstärkung und/oder Dämpfung auf das analoge Eingangssignal (Ai) in Abhängigkeit von einer auf ein Signal (sig), von welchem das besagte Eingangssignal (Di) von der externen Verarbeitungseinheit (12) abgeleitet ist, angewendete Verstärkung und/oder Dämpfung anzuwenden.

6. Verfahren nach Anspruch 5, wobei die besagten Verstärkermittel (130) variable Vorverstärkermittel (132) umfassen, welche eine variable Verstärkung und/oder Dämpfung auf das besagte analoge Eingangssignal (Ai) anwenden, um ein vorverstärktes Eingangssignal (pAi) zu erhalten, und wobei die besagten Verstärkermittel (130) weiterhin mindestens einen Leistungsverstärker (134) umfassen, welcher das besagte vorverstärkte Eingangssignal (pAi) verstärkt.

7. Verfahren nach einem der Ansprüche 5 bis 6, wobei die besagte variable Verstärkung und/oder Dämpfung von der besagten externen Signalverarbeitungseinheit (12), welche das digital modulierte Eingangssignal (Di) bereitstellt, gesteuert wird.

8. System, umfassend:
a) Eine Signalverarbeitungseinheit (12), weiche eine Funkkopfvorrichtung (100), insbesondere eine Funkkopfvorrichtung (100) gemäß einem der Ansprüche 1 bis 4, mit einem Eingangssignal (Di) versorgt, wobei die besagte Signalverarbeitungseinheit (12) einen Signalmodulator (12a) umfasst, welcher für den Empfang eines Eingangssignals (psiq) und für das Umwandeln des besagten Eingangssignals (psiq) in ein digital moduliertes Signal (ds) konfiguriert ist, und
b) mindestens eine Funkkopfvorrichtung (100) gemäß einem der Ansprüche 1 bis 4, wobei die besagte Funkkopfvorrichtung (100) mit der besagten Signalverarbeitungseinheit (12) assoziiert ist.

9. System nach Anspruch 8, wobei die besagte Signalverarbeitungseinheit (12) Verstärkermittel (12f) umfasst, welche dafür konfiguriert sind, den besagten Signalmodulator (12a) mit dem besagten Eingangssignal (psiq) mit einem vorbestimmten Eingangsleistungspegel zu versorgen.

10. System nach Anspruch 9, wobei die besagten Vorverstärkermittel (12f) dafür konfiguriert sind, den besagten Signalmodulator (12a) mit dem besagten Eingangssignal (psiq) mit einem konstanten Eingangsleistungspegel zu versorgen.

11. System nach einem der Ansprüche 8 bis 10, wobei die besagte Signalverarbeitungseinheit (12) dafür konfiguriert ist, einen Verstärkungsfaktor und/oder eine Dämpfung der Verstärkermittel (130, 132), welche in der Funkkopfvorrichtung (100) angeordnet und für das Anwenden einer variablen Verstärkung und/oder Dämpfung auf ein innerhalb der besagten Funkkopfvorrichtung (100) verarbeitetes analoges Signal (Ai) konfiguriert sind, zu steuern.

12. System nach Anspruch 11, wobei die besagte Signalverarbeitungseinheit (12) dafür konfiguriert ist, den besagten Verstärkungsfaktor und/oder die Dämpfung der besagten Verstärkermittel (130, 132), welche in der Funkkopfvorrichtung (100) angeordnet sind, in Abhängigkeit von einer Operation der besagten Vorverstärkermittel (12f), insbesondere in Abhängigkeit von einem Verstärkungsfaktor und/oder einer Dämpfung der besagten Vorverstärkermittel (12f), zu steuern.

13. System nach einem der Ansprüche 8 bis 12, wobei der besagte Signalmodulator (12a) ein Bandpass-Delta-Sigma-Modulator, BPDSM, ist.

## Revendications

1. Tête hertzienne (100) pour recevoir un signal d'entrée de la part d'une unité de traitement de signal externe (12) et pour délivrer un signal de sortie (RF_out) à radiofréquence, RF, qui dépend dudit signal d'entrée, ladite tête hertzienne (100) comprenant :
- une interface d'entrée (110) qui est configurée pour recevoir un signal d'entrée à modulation numérique (Di) de la part de ladite unité de traitement de signal externe (12),
- des moyens de reconstruction (120) numérique vers analogique, N/A, configurés pour transformer ledit signal d'entrée à modulation numérique (Di, Di') en un signal d'entrée analogique (Ai), et
- des moyens amplificateurs (130) configurés pour amplifier ledit signal d'entrée analogique (Ai) en fonction d'une amplification et/ou d'une atténuation appliquée à un signal (siq) duquel est dérivé ledit signal d'entrée (Di) de l'unité de traitement externe (12), lesdits moyens amplificateurs (130) étant configurés pour appliquer un gain et/ou une atténuation variable au signal d'entrée analogique (Ai) à amplifier,
- lesdits moyens amplificateurs (130) étant configurés pour commander ladite unité de traitement de signal externe (12).

2. Tête hertzienne (100) selon la revendication 1, avec laquelle :
lesdits moyens amplificateurs (130) comprennent des moyens préamplificateurs variables (132) qui sont configurés pour appliquer un gain et/ou une atténuation variable audit signal d'entrée analogique (Ai) pour obtenir un signal d'entrée préamplifié (pAi).

3. Tête hertzienne (100) selon la revendication 2, avec laquelle lesdits moyens amplificateurs (130) comprennent en outre au moins un amplificateur de puissance (134) qui est configuré pour amplifier ledit signal d'entrée préamplifié (pAi).

4. Tête hertzienne (100) selon l'une des revendications précédentes, avec laquelle un trajet de contre-réaction (160) est réalisé pour la linéarisation dudit signal de sortie RF (RF_out).

5. Procédé d'exploitation d'une tête hertzienne (100) pour recevoir un signal d'entrée de la part d'une unité de traitement de signal externe (12) et pour délivrer un signal de sortie (RF_out) à radiofréquence, RF, qui dépend dudit signal d'entrée, ledit procédé comprenant les étapes suivantes :
- réception d'un signal d'entrée à modulation numérique (Di) de la part de ladite unité de traitement de signal externe (12) au moyen d'une interface d'entrée (110),
- transformation dudit signal d'entrée à modulation numérique (Di, Di') en un signal d'entrée analogique (Ai) au moyen de moyens de reconstruction (120) numérique vers analogique, N/A,
- amplification dudit signal d'entrée analogique (Ai) au moyen de moyens amplificateurs (130) qui sont configurés pour appliquer un gain et/ou une atténuation variable au signal d'entrée analogique (Ai) à amplifier,
- lesdits moyens amplificateurs (130) étant configurés pour être commandés par ladite unité de traitement de signal externe (12) et appliquer ledit gain et/ou ladite atténuation variable au signal d'entrée analogique (Ai) en fonction d'une amplification et/ou atténuation appliquée à un signal (siq) duquel est dérivé ledit signal d'entrée (Di) de l'unité de traitement externe (12).

6. Procédé selon la revendication 5, selon lequel lesdits moyens amplificateurs (130) comprennent des moyens préamplificateurs variables (132) qui appliquent un gain et/ou une atténuation variable audit signal d'entrée analogique (Ai) pour obtenir un signal d'entrée préamplifié (pAi), et selon lequel lesdits moyens amplificateurs (130) comprennent en outre au moins un amplificateur de puissance (134) qui amplifie ledit signal d'entrée préamplifié (pAi).

7. Procédé selon l'une des revendications 5 à 6, selon lequel ledit gain et/ou ladite atténuation variable est commandé(e) par ladite unité de traitement de signal externe (12) qui délivre le signal d'entrée à modulation numérique (Di).

8. Système comprenant :
a) une unité de traitement de signal (12) pour délivrer à une tête hertzienne (100), notamment une tête hertzienne (100) selon l'une des revendications 1 à 4, un signal d'entrée (Di), ladite unité de traitement de signal (12) comprenant un modulateur de signal (12a) qui est configuré pour recevoir un signal d'entrée (psiq) et pour transformer ledit signal d'entrée (psiq) en un signal à modulation numérique (ds), et
b) au moins une tête hertzienne (100) selon l'une des revendications 1 à 4, ladite tête hertzienne (100) étant associée avec ladite unité de traitement de signal (12).

9. Système selon la revendication 8, avec lequel ladite unité de traitement de signal (12) comprend des moyens préamplificateurs (12f) qui sont configurés pour délivrer audit modulateur de signal (12a) ledit signal d'entrée (psiq) à un niveau de puissance d'entrée prédéterminé.

10. Système selon la revendication 9, avec lequel lesdits moyens préamplificateurs (12f) sont configurés pour délivrer audit modulateur de signal (12a) ledit signal d'entrée (psiq) à un niveau de puissance d'entrée constant.

11. Système selon l'une des revendications 8 à 10, avec lequel ladite unité de traitement de signal (12) est configurée pour commander un facteur de gain et/ou d'atténuation de moyens amplificateurs (130, 132) qui sont disposés à l'intérieur de ladite tête hertzienne (100) et qui sont configurés pour appliquer un gain et/ou une atténuation variable à un signal analogique (Ai) qui est traité à l'intérieur de ladite tête hertzienne (100).

12. Système selon la revendication 11, avec lequel ladite unité de traitement de signal (12) est configurée pour commander ledit facteur de gain et/ou d'atténuation desdits moyens amplificateurs (130, 132) qui sont disposés à l'intérieur de ladite tête hertzienne (100) en fonction d'une opération desdits moyens préamplificateurs (12f), notamment en fonction d'un facteur de gain et/ou d'atténuation desdits moyens préamplificateurs (12f).

13. Système selon l'une des revendications 8 à 12, avec lequel ledit modulateur de signal (12a) est un modulateur delta sigma passe-bande, BPDSM.
